# EUROPEAN PATENT APPLICATION

(11) **EP 2 154 188 A1**
(43) Date of publication of application: **17.02.2010**
(21) Application number: 09164526.7
(22) Date of filing: 03.07.2009
(51) Int. Cl.: C08K 3/22, H01L 33/00, H01L 21/312, H01L 23/29

(54) **Resin composition containing fine metal oxide particles**

(30) Priority: 06.08.2008 JP 2008203049
(71) Applicant: Nitto Denko Corporation, Ibaraki-shi Osaka (JP)
(72) Inventor: Hirano, Keisuke, Osaka (JP)
(74) Representative: HOFFMANN EITLE

(57) **Abstract**

A resin composition comprising fine metal oxide particles, wherein the resin composition is obtained by a step comprising subjecting (a) a silicon-containing compound represented by the formula (I): 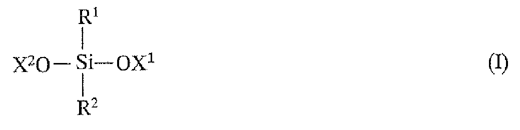 wherein each of R¹ and R² is independently an alkyl group or a phenyl group; and each of X¹ and X² is independently an alkyl group; and (b-i) a poly(dimethyl siloxanes) containing a methoxy group in an amount of from 10 to 50% by weight, or (b-ii) a silicon-containing compound represented by the formula (II): 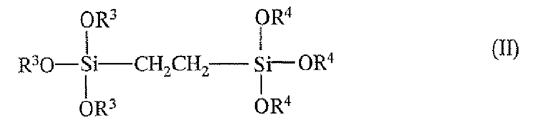 wherein each of R³ and R⁴ is independently a methyl group, an ethyl group, or a propyl group, to a reaction, in the presence of a dispersion of the fine metal oxide particles. The resin composition of the present invention can be suitably used for, for example, encapsulating materials, coating materials, molding materials, surface-protecting materials, adhesive agents, bonding agents, and the like. Especially, in cases where the resin composition of the present invention is used as an encapsulating material, the resin composition is suitably used for, for example, a photosemiconductor device mounted with blue or white LED elements (backlights for liquid crystal displays, traffic lights, outdoor big displays, advertisement sign boards, and the like).

## Description

### FIELD OF THE INVENTION

The present invention relates to a resin composition containing fine metal oxide particles, and a photosemiconductor device obtained by using the resin composition.

### BACKGROUND OF THE INVENTION

Use of silicone resins having excellent heat resistance and light-extracting efficiency has been disclosed (for example, Japanese Patent Laid-Open Nos. 2005-229048 and 2006-324596). Further, in order to improve the light-extracting efficiency, it has been desired to increase a refractive index of a resin. In view of the above, as a means of increasing the refractive index of the resin, dispersion of fine metal oxide particles having a high refractive index has been considered.

### SUMMARY OF THE INVENTION

The present invention relates to:
[1] a resin composition containing fine metal oxide particles, wherein the resin composition is obtained or obtainable by a step including subjecting
   (a) a silicon-containing compound represented by the formula (I): 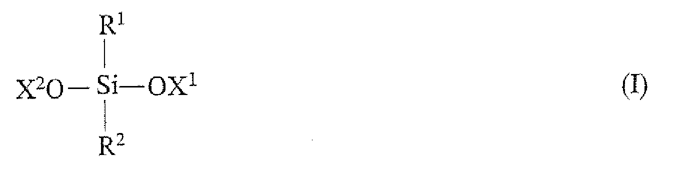 wherein each of R¹ and R² is independently an alkyl group or a phenyl group; and each of X¹ and X² is independently an alkyl group; and
   (b-i) a poly(dimethyl siloxanes) containing a methoxy group in an amount of from 10 to 50% by weight, or
   (b-ii) a silicon-containing compound represented by the formula (II): 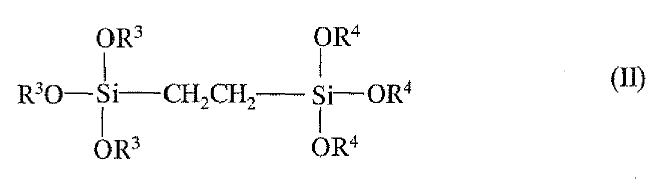 wherein each of R³ and R⁴ is independently a methyl group, an ethyl group, or a propyl group, to a reaction, in the presence of a dispersion of the fine metal oxide particles; and
[2] a photosemiconductor device containing a photosemiconductor element encapsulated with the resin composition as defined in the above [1].

### DETAILED DESCRIPTION OF THE INVENTION

There are some disadvantages that it is difficult to disperse the fine metal oxide particles without being aggregated because the silicone resins are highly hydrophobic, and that it is difficult to obtain a transparent resin because the aggregated fine metal oxide particles make the resin opaque.

In addition, a dispersion treatment is generally carried out in order to exhibit the properties of fine metal oxide particles. However, a long dispersion time may be necessitated for the dispersion treatment in some cases, so that there is a disadvantage that crystals of the fine metal oxide particles and the like are disintegrated, thereby lowering the performance and the like. In view of the above, it is desired that fine metal oxide particles are dispersed in a resin without carrying out a dispersion treatment.

The present invention relates to a resin composition in which fine metal oxide particles are stably dispersed in a resin without carrying out a dispersion treatment, so that the resin composition is capable of having a high refractive index and high transparency; and a photosemiconductor device containing a photosemiconductor element encapsulated with the resin composition.

The resin composition of the present invention exhibits some excellent effects that fine metal oxide particles are stably dispersed in a resin without carrying out a dispersion treatment, so that the resin composition is capable of having a high refractive index and high transparency. In addition, the photosemiconductor element is encapsulated with the resin composition, so that the photosemiconductor device can be provided with excellent light-extracting efficiency.

These and other advantages of the present invention will be apparent from the following description.

The resin composition of the present invention is obtained by a step including subjecting (a) a silicon-containing compound represented by the formula (I), and (b-i) a poly(dimethyl siloxanes) containing a methoxy group in an amount of from 10 to 50% by weight, or (b-ii) a silicon-containing compound represented by the formula (II) to a reaction, in the presence of a dispersion of fine metal oxide particles, wherein the resin composition contains the above fine metal oxide particles. In the resin composition, (a) the silicon-containing compound represented by the formula (I), and (b-i) the poly(dimethyl siloxanes) containing a methoxy group in an amount of from 10 to 50% by weight, or (b-ii) the silicon-containing compound represented by the formula (II) are independently reacted with the fine metal oxide particles and at the same time polymerized, to form a resin. Therefore, it is considered that dispersibility of the fine metal oxide particles is excellent without carrying out a dispersion treatment, so that the resin composition is capable of having a high refractive index and high transparency. The term "transparency" as used in the present invention refers to those expressed by light transmittance and haze described later. In a case of having a high light transmittance and a low haze, it is expressed that transparency is high.

The fine metal oxide particles usable in the present invention may be any ones so long as the effects of the present invention are not impaired. The fine metal oxide particles include fine particles of titanium oxide, zirconium oxide, barium titanate, zinc oxide, lead titanate, and the like, each having a high refractive index, from the viewpoint of obtaining a high refractive index, and these fine metal oxide particles can be used alone or in a combination of two or more kinds.

The fine metal oxide particles have an average primary particle size of preferably from 1 to 100 nm, more preferably from 1 to 50 nm, and even more preferably from 1 to 20 nm, from the viewpoint of obtaining excellent transparency even in a state where the particles are dispersed in the resin in a high concentration. The average primary particle size can be determined by the measurement of a particle size of particle dispersion by a dynamic light scattering method, or direct observation with a transmission electron microscope.

In the present invention, it is preferable that the fine metal oxide particles are dispersed in a dispersion (also referred to as "dispersion of the fine metal oxide particles") to be used, and a dispersion medium includes water, alcohols, ketone-based solvents, acetamide-based solvents, and the like, among which it is preferable to use water. The amount of the fine metal oxide particles (solid content) is preferably from 10 to 40% by weight, more preferably from 20 to 40% by weight, and even more preferably from 30 to 40% by weight, of the dispersion, from the viewpoint of efficiently reacting at the surface of the particles. As the dispersion of the fine metal oxide particles described above, a commercially available product such as a dispersion of titanium oxide particles of NEOSUNVEIL or QUEEN TITANIC Series commercially available from Catalyst & Chemicals Ind. Co., Ltd. (CCIC), or Tynoc commercially available from Taki Chemical Co., Ltd.; or a dispersion of zirconium oxide particles of ZSL Series commercially available from Daiichi Kigenso Kagaku Kogyo Co., Ltd., NZD Series commercially available from Sumitomo Osaka Cement Co., Ltd., or Nano-Use Series commercially available from Nissan Chemical Industries, Ltd.; or the like can be used.

The dispersion of the fine metal oxide particles is used in an amount of preferably from 5 to 30% by weight, and more preferably from 8 to 25% by weight, of the mixture subjected to the reaction, from the viewpoint of refractive index.

The silicon-containing compound subjected to the reaction in the present invention is a compound represented by the formula (I): 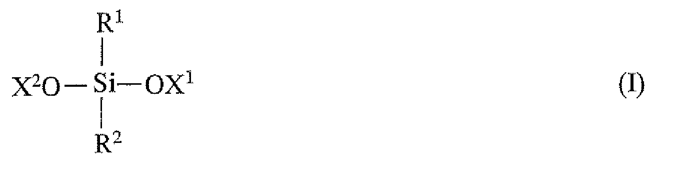 wherein each of R¹ and R² is independently an alkyl group or a phenyl group; and each of X¹ and X² is independently an alkyl group.

Each of R¹ and R² in the formula (I) is independently an alkyl group or a phenyl group, and the alkyl group has the number of carbon atoms of preferably from 1 to 18, more preferably from 1 to 12, and even more preferably from 1 to 6, from the viewpoint of controlling hydrophilicity/hydrophobicity of the surface of the particles, efficiency of polycondensation reaction of the alkoxysilane, and the like. Specific examples of the alkyl group include a methyl group, an ethyl group, a propyl group, an isopropyl group, and the like. Among them, it is preferable that both of R¹ and R² are a methyl group.

Each of X¹ and X² in the formula (I) is independently an alkyl group, and the alkyl group has the number of carbon atoms of preferably from 1 to 4, and more preferably from 1 to 2, from the viewpoint of reactivity at the surface of the particles, and a rate of hydrolysis. Specific examples of the alkyl group include a methyl group, an ethyl group, and the like. Among them, it is preferable that both of X¹ and X² are a methyl group.

The silicon-containing compound represented by the formula (I) includes diphenyldimethoxysilane, dimethyldimethoxysilane, dimethyldiethoxysilane, diphenyldiethoxysilane, diethyldimethoxysilane, diethyldiethoxysilane, diisopropyldimethoxysilane, diisopropyldiethoxysilane, methylphenyldimethoxysilane, methylphenyldiethoxysilane, and the like, and these silicon-containing compounds can be used alone or in a combination of two or more kinds. Among them, dimethyldimethoxysilane where both R¹ and R² are a methyl group, and both X¹ and X² are a methyl group in the formula (I) is preferred.

A commercially available product of the silicon-containing compound represented by the formula (I) is exemplified by KBM22 (dimethyldimethoxysilane, commercially available from Shin-Etsu Chemical Co., Ltd.), and the like.

The silicon-containing compound represented by the formula (I) is used in an amount of preferably from 5 to 20% by weight, and more preferably from 10 to 20% by weight, of the mixture subjected to the reaction, from the viewpoint of moldability of the molded article.

In addition, in the present invention,
(b-i) a poly(dimethyl siloxanes) containing a methoxy group in an amount of from 10 to 50% by weight, or
(b-ii) a silicon-containing compound represented by the formula (II): 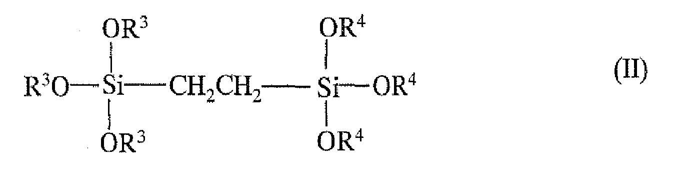 wherein each of R³ and R⁴ is independently a methyl group, an ethyl group, or a propyl group, is subjected to a reaction.

The poly(dimethyl siloxanes) containing a methoxy group in an amount of from 10 to 50% by weight is, for example, a compound at least having one or more dimethyl siloxane structures, and a structure in which one or more methoxy groups are bound to a silicon atom at a molecular end.

In addition, the above poly(dimethyl siloxanes) contains a methoxy group in an amount of from 10 to 50% by weight, and preferably from 20 to 50% by weight, from the viewpoint of reactivity at the surface of the particles, and efficiency of the polycondensation reaction of the silanes themselves. The amount of the methoxy group contained is expressed by a ratio of molecular weights of the methoxy group to the entire compound.

A commercially available product of the poly(dimethyl siloxanes) containing a methoxy group in an amount of from 10 to 50% by weight is exemplified by KC-89 (commercially available from Shin-Etsu Chemical Co., Ltd.), KR-500 (commercially available from Shin-Etsu Chemical Co., Ltd.), X-40-9225 (commercially available from Shin-Etsu Chemical Co., Ltd.), and the like.

In addition, each of R³ and R⁴ in the compound represented by the formula (II) is independently a methyl group, an ethyl group, or a propyl group. Among them, it is preferable that R³ is a methyl group, and R⁴ is an ethyl group.

The method for producing a silicon-containing compound represented by the formula (II) includes, but not limited to, for example, a method including the steps of subjecting a mixture of triethoxysilane and vinyltrimethoxysilane to a nitrogen replacement in the presence of toluene, adding a catalyst thereto, reacting the components at a temperature of from 20° to 80°C for 1 to 3 hours while stirring, cooling the reaction mixture to room temperature, and distilling off the solvent.

The poly(dimethyl siloxanes) containing a methoxy group in an amount of from 10 to 50% by weight or the silicon-containing compound represented by the formula (II) is used in an amount of preferably from 5 to 45% by weight, more preferably from 10 to 40% by weight, and even more preferably from 13 to 40% by weight, of the mixture subjected to the reaction, from the viewpoint of refractive index.

It is preferable that (a) the silicon-containing compound represented by the formula (I), and (b-i) the poly(dimethyl siloxanes) containing a methoxy group in an amount of from 10 to 50% by weight or (b-ii) the silicon-containing compound represented by the formula (II), which are used in the reaction in the presence of a dispersion of the fine metal oxide particles, are blended, so as to have a weight ratio, i.e. [the silicon-containing compound represented by the formula (I)/the poly(dimethyl siloxanes) containing a methoxy group in an amount of from 10 to 50% by weight or the silicon-containing compound represented by the formula (II)], of preferably from 3/1 to 1/3, more preferably from 3/1 to 1/2, and even more preferably from 2/1 to 1/2, from the viewpoint of reactivity. When the above weight ratio is smaller than 1/3, hydrophobicity of the resin becomes too high, thereby leading to cause aggregation of the particles, and when the above weight ratio is larger than 3/1, degree of crosslinking becomes too high, thereby leading to cause gelation.

When the above components are subjected to the reaction in the presence of the dispersion of fine metal oxide particles, besides the above components, a component such as water, methanol, 2-propanol, or methyl ethyl ketone may be contained, from the viewpoint of solubility of the reaction compound. The component is used in an amount of preferably from 0 to 50% by weight, of the mixture subjected to the reaction.

In the present invention, the mixture is subjected to the reaction using the above components, and the reaction includes, for example, mixing (a) a silicon-containing compound represented by the formula (I), (b-i) a poly(dimethyl siloxanes) containing a methoxy group in an amount of from 10 to 50% by weight or (b-ii) a silicon-containing compound represented by the formula (II), methanol, 2-propanol, and the like, in the presence of a dispersion of fine metal oxide particles, and reacting the components at a temperature of preferably from 20° to 80°C, and more preferably from 40° to 60°C, for preferably from 1 to 6 hours, and more preferably from 2 to 4 hours while stirring, without being limited thereto. Although not wanted to be limited by theory, it is considered that the reaction is caused by a reaction including converting a poly(dimethyl siloxanes) containing a methoxy group in an amount of from 10 to 50% by weight and each of the silicon-containing compounds into the form of a silanol utilizing a reaction between a hydrolytic group, for example, a methoxy group, which is an organic substituent of a poly(dimethyl siloxanes) containing a methoxy group in an amount of from 10 to 50% by weight and each of the silicon-containing compounds, and water, and reacting each of the silanol groups and the surface of fine metal oxide particles, and further subjecting the poly(dimethyl siloxanes) containing a methoxy group in an amount of from 10 to 50% by weight and each of the silicon-containing compounds themselves to a polycondensation reaction to form a resin.

In addition, after the reaction, the reaction mixture is cooled to room temperature, and the solvent such as water or an alcohol is distilled off, whereby a resin composition containing fine metal oxide particles can be obtained. The resin composition obtained according to the present invention is a resin composition in which the fine metal oxide particles are homogeneously and stably dispersed in the resin.

The ratio of the fine metal oxide particles to the entire amount of the resin composition is preferably from 1 to 15% by volume, and more preferably from 5 to 15% by volume, from the viewpoint of refractive index.

Further, it is preferable that the resin composition has a viscosity (at 25°C) of, for example, from 1000 to 10000 mPa•s.

The resin composition may be used in the form of a solution (a resin composition solution) prepared by, for example, dissolving the resin composition in a mixed solvent of methanol/tetrahydrofuran, and the resin composition can be used in an amount of preferably from 10 to 50% by weight, and more preferably from 20 to 50% by weight, of the mixed solvent, from the viewpoint controlling the film thickness upon coating. It is preferable that using the resin composition solution, a film is formed into a thickness of preferably from 3 to 100 µm, and more preferably from 10 to 50 µm.

The film formed by using the resin composition in the present invention has light transmittance of preferably 80% or more, more preferably 90% or more, and even more preferably 95% or more, from the viewpoint of light-extracting efficiency. The light transmittance can be determined in the manner as described in Examples set forth below.

Similarly, the film formed by using the resin composition in the present invention has haze of preferably from 0 to 5%, more preferably from 0 to 4%, and even more preferably from 0 to 3%, from the viewpoint of light-extracting efficiency. The haze can be determined in the manner as described in Examples set forth below.

The film formed by using the resin composition in the present invention has a refractive index of preferably 1.41 or more, more preferably 1.45 or more, and even more preferably 1.50 or more, from the viewpoint of light-extracting efficiency. The refractive index can be determined, for example, by using an Abbe refractometer.

The resin composition of the present invention can be suitably used for, for example, encapsulating materials, coating materials, molding materials, surface-protecting materials, adhesive agents, bonding agents, and the like. Especially, in cases where the resin composition of the present invention is used as an encapsulating material, the resin composition is suitably used for, for example, photosemiconductor devices mounted with blue or white LED elements (backlights for liquid crystal displays, traffic lights, outdoor big displays, advertisement sign boards, and the like). Therefore, it is preferable that the resin composition of the present invention is used in encapsulation of a photosemiconductor element. Further, the present invention also provides a photosemiconductor device containing a photosemiconductor element encapsulated with the above resin composition. Since the photosemiconductor element is encapsulated with the resin composition, the photosemiconductor device can be provided with excellent light-extracting efficiency.

The photosemiconductor device of the present invention can be produced by encapsulating, for example, LED elements with the above resin composition. Specifically, a photosemiconductor device can be produced by directly applying a resin composition (the resin composition solution) of the present invention in an appropriate thickness to a substrate mounted with LED elements according to any methods such as an applicator, casting, spin-coating, roll-coating or the like, and heating and drying the coating to a temperature of preferably from 50° to 150°C for preferably 1 to 3 hours, thereby encapsulating the photosemiconductor elements.

### EXAMPLES

The following examples further describe and demonstrate embodiments of the present invention. The examples are given solely for the purposes of illustration and are not to be construed as limitations of the present invention.

### Example 1

In a container equipped with a stirrer, a reflux condenser, and a nitrogen inlet tube, 1.7 g of methanol and 1.7 g of 2-propanol were added to 1.7 g of an aqueous dispersion of fine zirconium oxide particles having an average primary particle size of 5 nm (trade name: NZD-3005, commercially available from Sumitomo Osaka Cement Co., Ltd., solid content: 30% by weight). Thereto were added 0.9 g of a silicon-containing compound represented by the formula (I) dimethyldimethoxysilane (trade name: KBM22, commercially available from Shin-Etsu Chemical Co., Ltd., a compound in which each of R¹ and R² is a methyl group, and each of X¹ and X² is a methyl group), and 0.9 g of a poly(dimethyl siloxanes) containing a methoxy group in an amount of 45% by weight (trade name: KC-89, commercially available from Shin-Etsu Chemical Co., Ltd.), and the components were reacted at 60°C for 3 hours, while stirring. After the termination of the reaction, the reaction mixture was cooled to room temperature, water was first distilled off, and the alcohols were subsequently distilled off, to give a waxy, transparent resin composition containing fine zirconium oxide particles (the ratio of fine zirconium oxide particles to the entire amount of the resin composition: 9% by volume).

In addition, a solution prepared by dissolving the resin composition in a mixed solvent of methanol/tetrahydrofuran (1/1) in an amount of 30% by weight was applied to a glass plate so as to have a thickness of 10 µm on a dry basis, and the coating was dried at 150°C for 1 hour. The coating film obtained had a light transmittance at a wavelength of 450 nm of 98% and a haze of 0.3%. The refractive index of the coating film obtained was measured with an Abbe refractometer, and as a result, the refractive index was 1.47.

In addition, the resin composition solution was applied to a substrate mounted with blue emitting diodes with an applicator, and a coating was heated and dried at 150°C for 1 hour, thereby encapsulating the blue emitting diodes, to give a blue emitting diode device.

### Example 2

The same procedures as in Example 1 were carried out except that 0.9 g of a poly(dimethyl siloxanes) containing a methoxy group in an amount of 28% by weight (trade name: KR-500, commercially available from Shin-Etsu Chemical Co., Ltd.) was used in place of KC-89 used in Example 1, to give a resin composition (the ratio of fine zirconium oxide particles to the entire amount of the resin composition: 8% by volume).

In addition, a coating film obtained in the same manner as in Example 1 had a light transmittance of 97.1%, a haze of 0.1%, and a refractive index of 1.46. Further, blue light-emitting diodes were encapsulated in the same manner as in Example 1, to give a blue light-emitting diode device.

### Example 3

The same procedures as in Example 1 were carried out except that 0.9 g of a poly(dimethyl siloxanes) containing a methoxy group in an amount of 24% by weight (trade name: X-40-9225, commercially available from Shin-Etsu Chemical Co., Ltd.) was used in place of KC-89 used in Example 1, to give a resin composition (the ratio of fine zirconium oxide particles to the entire amount of the resin composition: 7% by volume).

In addition, a coating film obtained in the same manner as in Example 1 had a light transmittance of 98%, a haze of 0.2%, and a refractive index of 1.46. Further, blue light-emitting diodes were encapsulated in the same manner as in Example 1, to give a blue light-emitting diode device.

### Example 4

### [Production of Silicon-Containing Compound Represented by Formula (II)]

There were added together 3.28 g (20 mmol) of triethoxysilane, 2.96 g (20 mmol) of vinyltrimethoxysilane (trade name: KBM1003, commercially available from Shin-Etsu Chemical Co., Ltd.), and 10 mL of toluene, and the mixture was subjected to nitrogen replacement for 30 minutes. Next, 3 µL of a platinum catalyst (a xylene solution (2% Pt or less) of the trade name: Platinum (0)-1,3-divinyl-1,1,3,3-tetramethyldisiloxane complex, commercially available from Aldrich) was added to the mixture, and the components were reacted at 80°C for 3 hours while stirring. The reaction mixture was cooled to room temperature, and the solvents were distilled off from the cooled mixture, to give a silicon-containing compound represented by the formula (II). As a result of confirmation with ¹H-NMR, the structure of the resulting compound was such that R³ is a methyl group and R⁴ is an ethyl group.

A reaction was carried out under the same conditions as in Example 1 using the same experimental apparatus as in Example 1, except that 1.5 g of an aqueous dispersion of fine zirconium oxide particles having an average primary particle size of 5 nm (trade name: NZD-3005, commercially available from Sumitomo Osaka Cement Co., Ltd., solid content: 30% by weight), 1.5 g of methanol, 1.5 g of 2-propanol, 0.9 g of a silicon-containing compound represented by the formula (I) dimethyldimethoxysilane (trade name: KBM22, commercially available from Shin-Etsu Chemical Co., Ltd., a compound in which each of R¹ and R² is a methyl group, and each of X¹ and X² is a methyl group), and 0.9 g of the above silicon-containing compound represented by the formula (II) were added, to give a waxy, transparent resin composition containing fine zirconium oxide particles (the ratio of fine zirconium oxide particles to the entire amount of the resin composition: 8% by volume).

In addition, a coating film obtained in the same manner as in Example 1 had a light transmittance of 98%, a haze of 0.2%, and a refractive index of 1.50. Further, blue light-emitting diodes were encapsulated in the same manner as in Example 1, to give a blue light-emitting diode device.

### Comparative Example 1

A reaction was carried out under the same conditions as in Example 1 except that 0.9 g of methyltrimethoxysilane (trade name: KBM13, commercially available from Shin-Etsu Chemical Co., Ltd.), which is a single-end trifunctional alkoxysilane, was used in place of KC-89. Although the reaction mixture was transparent during the reaction, the reaction mixture became white turbid after distilling off the solvents, so that the fine metal oxide particles could not be re-dispersed.

### Comparative Example 2

The dispersion of fine zirconium oxide particles used in Example 1 was added to a reaction mixture previously prepared by reacting all the components in Example 1 except for the dispersion of fine zirconium oxide particles, and the mixture obtained was concentrated. However, the fine zirconium oxide particles were aggregated, and could not be re-dispersed.

### (Evaluation)

The light transmittance, the haze, and the refractive index mentioned above were evaluated by the following methods.

### (Light Transmittance)

The light transmittance was determined for a coating film formed by coating a glass plate with each of the resin compositions of Examples 1 to 4, with a spectrophotometer (U-4100, commercially available from Hitachi High-Technologies Corporation), at a wave length of 450 nm.

### (Haze)

The haze was determined for a coating film formed by coating a glass plate with each of the resin compositions of Examples 1 to 4, with a haze and reflectometer (HR-100, commercially available from MURAKAMI COLOR RESEARCH LABORATORY).

### (Refractive Index)

The refractive index was determined for a coating film formed by coating a glass plate with each of the resin compositions of Examples 1 to 4, with an Abbe refractometer (Model NAR-1T, commercially available from ATAGO CO., LTD.) at 25°C.

It can be seen from the above results that Examples 1 to 4 have excellent refractive indices and transparency, as compared to those of Comparative Examples 1 and 2. Therefore, the resin composition of the present invention, in which the fine metal oxide particles are stably dispersed without carrying out a dispersion treatment, can have a high refractive index and high transparency. In addition, a photosemiconductor device containing a photosemiconductor element encapsulated with the resin composition can be provided with excellent light-extracting efficiency.

The resin composition of the present invention can be suitably used for, for example, encapsulating materials, coating materials, molding materials, surface-protecting materials, adhesive agents, bonding agents, and the like. Especially, in cases where the resin composition of the present invention is used as an encapsulating material, the resin composition is suitably used for, for example, photosemiconductor devices mounted with blue or white LED elements (backlights for liquid crystal displays, traffic lights, outdoor big displays, advertisement sign boards, and the like).

The present invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A resin composition comprising fine metal oxide particles, wherein the resin composition is obtainable by a step comprising subjecting
(a) a silicon-containing compound represented by the formula (I): 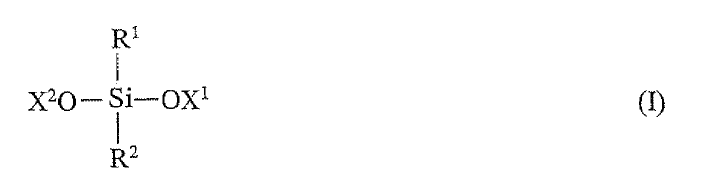 wherein each of R¹ and R² is independently an alkyl group or a phenyl group; and each of X¹ and X² is independently an alkyl group; and
(b-i) a poly(dimethyl siloxanes) containing a methoxy group in an amount of from 10 to 50% by weight, or
(b-ii) a silicon-containing compound represented by the formula (II): 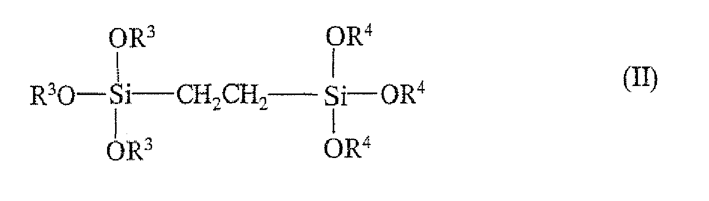 wherein each of R³ and R⁴ is independently a methyl group, an ethyl group, or a propyl group, to a reaction, in the presence of a dispersion of the fine metal oxide particles.

2. The resin composition according to claim 1, wherein the fine metal oxide particles are particles of titanium oxide or zirconium oxide having an average primary particle size of from 1 to 100 nm.

3. The resin composition according to claim 1 or 2, for use in encapsulation of a photosemiconductor element.

4. A photosemiconductor device comprising a photosemiconductor element encapsulated with the resin composition as defined in any one of claims 1 to 3.
